# EUROPEAN PATENT APPLICATION

(11) **EP 2 415 734 A2**
(43) Date of publication of application: **08.02.2012**
(21) Application number: 11176552.5
(22) Date of filing: 04.08.2011
(51) Int. Cl.: C04B 35/83

(54) **C/C composite material molded body and method for manufacturing the same**

(30) Priority: 04.08.2010 JP 2010174967
(71) Applicant: Ibiden Co., Ltd., Ogaki-shi, Gifu (JP)
(72) Inventor: Kato, Hideki, Gifu, 503-8503 (JP); Shikano, Haruhide, Gifu, 503-8503 (JP); Ando, Tomoyuki, Gifu, 503-8503 (JP)
(74) Representative: HOFFMANN EITLE

(57) **Abstract**

A C/C composite material molded body and a method for manufacturing the same are provided. The C/C composite material molded body includes carbon fibers, and a carbonaceous matrix. The C/C composite material molded body has a shell-like structure, an outer surface of which is configured by a three-dimensional curved surface or a combination of a plurality of surfaces, and which is configured by a continuous structure having a uniform composition as a whole. A longitudinal direction of the carbon fibers is oriented along the outer surface.

## Description

### BACKGROUND OF THE INTENTION

### Field of the Invention

The present invention relates to a C/C composite material molded body and a method for manufacturing the same. In particular, the present invention relates to a C/C composite material molded body containing carbon fibers and a carbonaceous matrix.

### Description of the Related Art

Since carbon fibers have high heat resistance and strength, they are composited with a carbon matrix to be used as a C/C composite material (carbon fiber reinforced carbon composite material) in various fields requiring heat resistance, chemical stability and strength. The C/C composite material includes various kinds depending upon a compositing method of carbon fibers, and various carbon fiber molded bodies can be formed by using the same.

The C/C composite material is comprised of a matrix made of a carbide such as a pitch and a thermosetting rein, and carbon fibers. There are various C/C composite materials depending upon a fixing method of carbon fibers such as a cloth laminating method using a carbon fiber cloth, a filament winding method using carbon fiber filaments, a method using a carbon fiber felt, and a sheet-forming method using a carbon fiber sheet-formed body.

The cloth laminating method is a method of obtaining a C/C composite material by laminating a woven fabric made of carbon fibers, impregnating the woven fabric with a matrix precursor such as a pitch and a thermosetting resin, followed by curing and calcination (see JP-A-H11-60373). A C/C composite material in a plate form can be obtained by laminating planar woven fabrics and uniaxially pressing the laminate. Also, a C/C composite material in a complicated shape of the papier-mache form can be obtained by sticking small cut woven fabric pieces to a die in a three-dimensional shape. Furthermore, a C/C composite material in a cylindrical shape can also be obtained by winding a planar woven fabric in a roll form while applying a pressure thereto and laminating it (cloth winding method).

The filament winding method is a method of obtaining a C/C composite material by winding a strand of carbon fibers around a mandrel while applying a tension thereto and then impregnating the wound strand with a matrix precursor such as a pitch and a thermosetting resin, followed by curing and calcination (see JP-A-H10-152391).

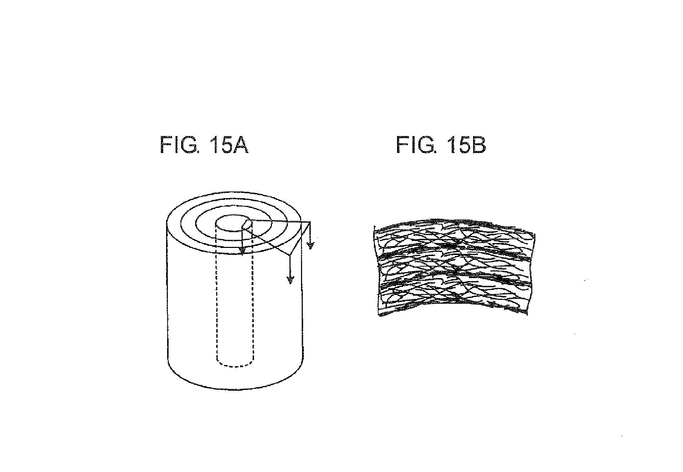

The method using a carbon fiber felt is a method of obtaining a C/C composite material by laminating long fibers of carbon fibers in a felt-like form and impregnating the laminate with a matrix precursor such as a pitch and a thermosetting resin, followed by curing and calcination (see JP-A-2000-143360). Similar to the cloth laminating method, according to this method, a planar C/C composite material, a cylindrical C/C composite material and a C/C composite material having a complicated shape can also be obtained. In particular, a cylindrical C/C composite material can also be obtained by winding up a planar felt in a roll form while applying a pressure thereto, followed by lamination (cloth winding method; see, for example, Figs. 15A and 15B).

Furthermore, there is proposed manufacturing a C/C composite material by a sheet-forming method (see JP-A-2002-68851 and JP-A-2002-97082). The C/C composite material of a sheet-forming method is obtained by suspending carbon fibers in a liquid to form a slurry, dipping a suction die having an aperture in this slurry, allowing the liquid in the slurry to pass into a rear surface of the suction die and depositing carbon fibers on the surface side of this suction die to form a molded material, following by drying and calcination. The C/C composite material of this sheet-forming type has such an advantage that a molded material having a relatively free shape can be obtained depending upon a shape of the suction die.

### SUMMARY OF THE INVENTION

In the manufacture of a C/C composite material, in the case of manufacturing a simple C/C composite material in a plate form, ends of the plate material are opened. Therefore, even when shrinkage is caused in a process of pressing and calcination, only a size of the whole becomes small, and a C/C composite material which is low in warp or deformation can be obtained.

In the case of manufacturing a C/C composite material in a plate form having a ring-like shape such as a cylinder, the filament winding method or the cloth winding method is adopted. In these methods, for the purpose of revealing a high density, a preliminarily molded body is formed by winding a cloth or filaments around a core while applying a tension thereto. Since the molded body is manufactured according to such a method, a thin-walled C/C composite material can be easily manufactured. However, in the manufacture of a thick-walled C/C composite material, a tension is applied to the cloth or filaments, and there is no end at which a stress is released in a circumferential direction of the preliminarily molded body. Therefore, due to a difference in the tension between an outer layer side and an inner layer side of the preliminarily molded body, the inner layer side is easily buckled. Furthermore, a lowering of a bonding force occurs due to the generation of shrinkage and carbonization of a binder component by calcination, whereby the inner layer side of the preliminarily molded body is more easily buckled. As a result, when the core is removed, the inner layer side of the preliminarily molded body is deformed by buckling, and a lowering of the strength occurs in its turn. For that reason, it is difficult to obtain a thick-walled C/C composite material by means of the filament winding method or cloth winding method.

Also, in the case of the method using a carbon fiber felt, several layers of a thin felt are laminated and molded. However, since a bonding force between the felts is small, separation is easy to occur. In particular, in the case of manufacturing a thick-walled C/C composite material, a compression stress is applied in a process of curing and calcination, and hence, when the core is removed, the inner layer side of the preliminarily molded body is easily buckled. That is, similar to the filament winding method and the cloth winding method, there is involved such a problem that deformation or a lowering of the strength occurs in the inner layer side of the preliminarily molded body due to buckling. For that reason, it is difficult to obtain a thick-walled C/C composite material by laminating carbon fiber felts.

Also, in the related-art manufacturing method of a C/C composite material, when warp or deformation is generated at a stage of curing and calcination of a preliminarily molded body, in the case where a dimensional tolerance in the product shape is small, or in the case where the product shape is not a simple shape such as a plate, it is necessary to perform processing such as cutting and joining.

However, in the filament winding method, the cloth winding method, the sheet winding method and so on, several layers of a filament, a cloth, a carbon fiber felt or the like are laminated to form a preliminarily molded body. Therefore, when the foregoing processing is performed, long fibers capable of keeping the strength are cut, the strength becomes partially weak, and separation is easy to occur between layers with weak strength.

Also, in order to obtain a three-dimensional structure using a cloth or a felt, in order to form a shape of a three-dimensional curved surface which cannot be formed from a plane, it is necessary to cut a planar sheet, or to divide it into small sheets and sticking them (hand layup). For that reason, there are involved such problems that not only sufficient coupling with each other is not obtainable in ends of the stuck sheets, but sufficient strength is not obtainable because interlaminar strength of the sheets is small; and that in a joint part of the cuts, its strength is small in both a surface direction and a thickness direction as compared with that in other portions.

Also, such a method as filament winding can be used for only a limited shape such as a cylindrical shape and a bowl shape, and it is difficult to use this method for a complicated shape.

Meanwhile, according to the sheet-forming method, by properly choosing a die, various three-dimensional structures can be obtained. However, in the related-art sheet-forming method, since the hydraulic resistance becomes gradually high at the time of sheet-forming, it is difficult to obtain a thick-walled sheet-formed body with a high density. For that reason, it is necessary to laminate several layers of a sheet-like sheet-formed body with a high density and laminate them.

On the other hand, according to the related-art sheet-forming method, it is at least possible to form a thick-walled sheet-formed body with a low density. However, it is necessary to perform a treatment step for the purpose of realizing a high density, such as infiltration of pyrolytic carbon into a sheet-formed body by means of a chemical vapor infiltration (CVI) treatment. In the sheet-formed body having been subjected to chemical vapor infiltration of pyrolytic carbon, there are involved such problems that pores between the fibers become few and the hardness increases, so that processing is hardly performed. Also, even when such a treatment step is introduced, it is difficult to sufficiently realize a high density.

As described above, according to the related-art methods, it is difficult to obtain a C/C composite material molded body having desired strength and high heat resistance. In particular, it is extremely difficult to form a silicon single crystal pull-up apparatus (for example, a heat insulating cylinder of crucible), a three-dimensional curved surface or a composite structure of a curved surface and a plane. Also, even if a molded body could be obtained, a mechanically weak place is presented, so that a probability of causing breakage from the place is high. For that reason, a C/C composite material molded body with high strength, high density and high heat resistance is demanded.

The present invention has been made in view of the above circumstances, and an object of the present invention is to provide a C/C composite material molded body with high strength, high density and high heat resistance.

An embodiment of the present invention provides the following:
[1] A C/C composite material molded body comprising:
   carbon fibers; and
   a carbonaceous matrix,
   wherein the C/C composite material molded body has a shell-like structure, an outer surface of which is configured by a three-dimensional curved surface or a combination of a plurality of surfaces, and which is configured by a continuous structure having a uniform composition as a whole, and
   wherein a longitudinal direction of the carbon fibers is oriented along the outer surface.
[2] The C/C composite material molded body according to [1],
   wherein the outer surface is any of (A) a combination of a three-dimensional curved surface and a plane or a curved surface, (B) a combination of a curved surface and a plane, (C) a combination of a curved surface and a curved surface, or (D) a combination of a plurality of planes.
[3] The C/C composite material molded body according to [1] or [2],
   wherein the carbon fibers include a linear fiber.
[4] The C/C composite material molded body according to any one of [1] to [3],
   wherein thin piece bodies in which the longitudinal direction of the carbon fibers is oriented along the outer surface of the shell-like structure are formed, and the shell-like structure is configured by a laminate of the thin piece bodies.
[5] The C/C composite material molded body according to any one of [1] to [4], wherein the carbon fibers have an average fiber length of less than 1 mm.
[6] The C/C composite material molded body according to any one of [1] to [5],
   wherein an orienting component of the carbon fibers in a vertical direction to the outer surface of the shell-like structure is continuously present.
[7] The C/C composite material molded body according to any one of [1] to [6],
   wherein the C/C composite material molded body has a bulk density ranging from 1.2 g/cm³ to 1.8 g/cm³.
[8] A method for manufacturing a C/C composite material molded body including carbon fibers and a carbonaceous matrix surrounding the carbon fibers, wherein the C/C composite material molded body has a shell-like structure, an outer surface of which is configured by a three-dimensional curved surface or a combination of a plurality of surfaces, and which is configured by a continuous structure having a uniform composition as a whole, and a longitudinal direction of the carbon fibers is oriented along the outer surface,
   the method comprising:
   (A) suspending the carbon fibers and a binder that is a precursor component of the carbonaceous matrix in a liquid and adding an aggregating agent to aggregate the carbon fibers and the binder, thereby forming flocks;
   (B) filtering the liquid having the flocks formed therein by a die having a porous die face configured by a continuous surface of a three-dimensional curved surface or a combination of continuous plurality surfaces to laminate the flocks on a surface of the porous die face, thereby forming a laminate of flocks;
   (C) pressurizing the laminate of flocks and orienting the longitudinal direction of the carbon fibers in a surface direction of the porous die face to convert the flocks into thin pieces, thereby forming a laminate of thin piece body precursor; and
   (D) calcining the laminate of thin piece body precursor and carbonizing the binder to form the carbonaceous matrix, thereby forming a laminate of thin piece bodies.
[9] The method according to [8],
   wherein the filtering in the step (B) is a suction filtering.
[10] The method according to [8] or [9],
   wherein the step (A) is a step of suspending the carbon fibers including a linear fiber, a first binder that is a precursor component of the carbonaceous matrix and a second binder that is a component for coupling the carbon fibers and the first binder, in the liquid, and adding the aggregating agent to aggregate the carbon fibers and the binder, thereby forming the flocks.
[11] The method according to any one of [8] to [10],
   wherein the step (C) is a step of undergoing heat compression by using an autoclave in a state where the laminate of flocks is covered by a film and orienting the longitudinal direction of the carbon fibers in the surface direction of the porous die face to convert the flocks into the thin pieces, thereby forming the laminate of thin piece body precursor.

According to the above configuration, it is possible to obtain a C/C composite material molded body in which interlaminar separation of the C/C composite material molded body hardly occurs, and high strength and high heat resistance are revealed. Also, it is possible to easily form a C/C composite material molded body that is a three-dimensional structure of a C/C composite material.

Also, since a three-dimensional curved surface or a joint part of surfaces can be formed as a continuous structure without requiring cutting or bonding, it is possible to form the whole of a molded body in a structurally uniform configuration.

Accordingly, it is possible to obtain a three-dimensional C/C composite material molded body with high strength as a whole because it is a shell-like structure, an outer surface of which is configured by a three-dimensional curved surface or a combination of a plurality of surfaces, and which is configured by a continuous structure having a uniform composition as a whole; a longitudinal direction of the carbon fibers is oriented along the outer surface. Therefore, even on a three-dimensional curved surface or a complicated inflected surface on which a curvature steeply changes, there is no defect which is weak from the strength standpoint as compared with other portions.

### BRIEF DESCRIPTION OF THE DRAWINGS

The above and other aspects of the present invention will become more apparent and more readily appreciated from the following description of illustrative embodiments of the present invention taken in conjunction with the attached drawings, in which:
Figs. 1A to 1E are views showing a molded body of Embodiment 1, specifically, Fig. 1A is a perspective view; Fig. 1B is a sectional view; Fig. 1C is an enlarged view of a part of Fig. 1B; Fig. 1D is a more enlarged view of a part of Fig. 1C; and Fig. 1E is a more enlarged view of a part of Fig. 1D;
Fig. 2 is a step flow chart of a manufacturing method of a molded body of Embodiment 1;
Figs. 3A1 to 3D are outline views showing a manufacturing method of a molded body of Embodiment 1;
Figs. 4A to 4D are views showing a molded body of Embodiment 2, specifically, Fig. 4A is a perspective view; Fig. 4B is a sectional view; Fig. 4C is an enlarged view of a part of Fig. 4B; and Fig. 4D is a more enlarged view of a part of Fig. 4C:
Figs. 5A to 5D are outline views showing a manufacturing method of a molded body of Embodiment 2;
Figs. 6A and 6B are views of a molded body of Embodiment 3, specifically, Fig. 6A is a perspective view, and Fig. 6B is a sectional view;
Figs. 7A and 7B are outline views showing a manufacturing method of a molded body of Embodiment 3;
Figs. 8A and 8B are views of a molded body of Embodiment 4, specifically, Fig. 8A is a perspective view, and Fig. 8B is a sectional view;
Figs. 9A and 9B are schematic views showing a cut-out direction and a bending test direction of a sample for measuring physical properties of a C/C composite material molded body of each of Example and Comparative Example;
Fig. 10A is a photograph of a sectional view of a molded body of Example, and Fig. 10B is a photograph of a sectional view of a molded body of Comparative Example;
Fig. 11A is an enlarged photograph of the surface of a molded body of Example, Fig. 11B is a photograph of thin piece bodies found on the surface of a molded body of Example; and Fig. 11C is a photograph of thin piece bodies separated from the surface of a molded body of Example;
Fig. 12A is a scanning electron microscopic photograph of a section in which a felt is wound and laminated around a mandrel in a sheet winding method of Comparative Example, and Fig. 12B is a schematic view of Fig. 12A;
Figs. 13A to 13C are scanning electron microscopic photographs of a section of a molded body, specifically, Fig. 13A is a photograph with a magnification of 100; Fig. 13B is a photograph with a magnification of 200; and Fig. 13C is a photograph with a magnification of 500;
Fig. 14A is a polarizing microscopic photograph of a section of a molded body, and Fig. 14B is a polarizing microscopic photograph of a section of molded body of Comparative Example;
Figs. 15A and 15B are views showing a molded body of Comparative Example, specifically, Fig. 15A is a perspective view, and Fig. 15B is a sectional schematic view; and
Figs. 16A and 16B are schematic views showing a method of applying an impact in a peeling test in each of Example and Comparative Example.

### DETAILED DESCRIPTION

Illustrative embodiments of the present invention will be described by reference to the drawings.

The C/C composite material molded body according to an embodiment of the present invention (hereinafter also referred to as "molded body") is a molded body that is a shell-like structure which is configured by a continuous surface of any of a three-dimensional curved surface or a combination of plurality of surfaces, each of which is configured by a carbon fiber-reinforced carbon composite material containing carbon fibers and a carbonaceous matrix, and which has a continuous structure having a uniform composition as a whole.

Preferably, an orientation component of carbon fibers in a direction vertical to the surface of this shell-like structure is continuously existent. Also, preferably, the carbon fibers include a linear fiber. More preferably, this shell-like structure is configured by a laminate of thin piece bodies. Also, preferably, the carbon fibers configuring a thin piece body in which a longitudinal direction of the carbon fibers is oriented in a surface direction of the molded body within the carbonaceous matrix. The C/C composite material molded body is configured as a molded body by a laminate of the thin piece bodies.

The three-dimensional curved surface as referred to herein means a surface which cannot be materialized by deforming a plane. Namely, the three-dimensional curved surface as referred to herein means a surface which cannot be developed into a plane and includes not only geometrical surfaces such as a spherical surface, a parabolic surface and a hyperbolic surface but surfaces such as a convex surface, a concave surface and a surface curved in a saddle-like form. The term "plurality surfaces" as referred to herein may be a combination of a plural number of surfaces inclusive of not only the foregoing three-dimensional curved surface but a surface which can be developed into a plane, such as a corrugated surface, a cylindrical curved surface and a conical curved surface, and a plane.

(Embodiment 1)

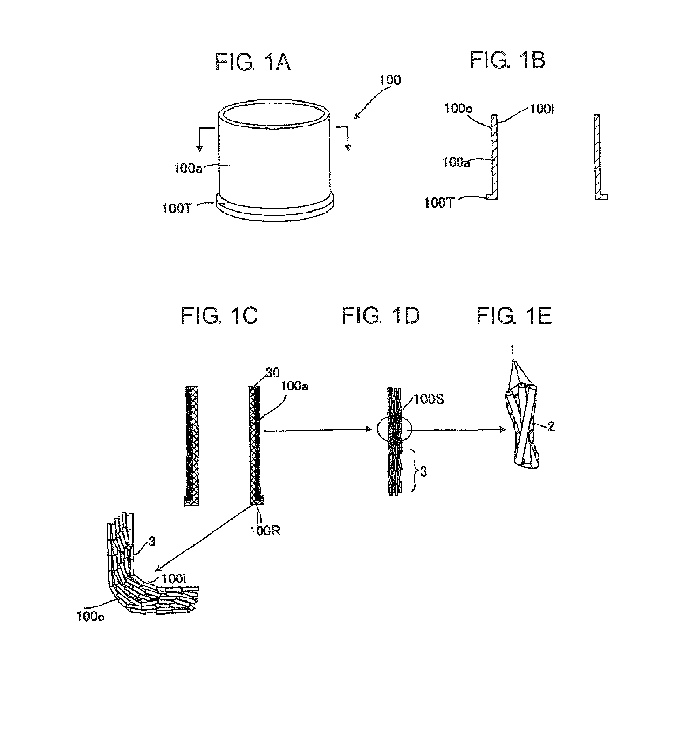

A C/C composite material molded body according to Embodiment 1 of the present invention is described by reference to Figs. 1A to 1E.

Figs. 1A and 1B are a perspective view and a sectional view of a C/C composite material molded body 100 of Embodiment 1, respectively. Figs. 1C to 1E are a sectional view, an enlarged view of a part and a more enlarged view of the part of Fig. 1A, respectively. This C/C composite material molded body includes a cylindrical part 100a and a flange part 100T continuously formed in a lower end of the cylindrical part 100a along a peripheral surface thereof. As shown in Figs. 1D and 1E, in this C/C composite material molded body 100, in a most number of carbon fibers 1, a longitudinal direction of those fibers is oriented in a surface direction of the molded body 100 within a carbonaceous matrix 2, whereby thin piece bodies (sheet-like small pieces) 3 are formed. In other words, the molded body 100 is configured by a laminate of the thin piece bodies 3. That is, this C/C composite material molded body is a shell-like structure which is configured by a continuous surface composed of a combination of plural surfaces and which is configured by a continuous body having a uniform composition as a whole. The carbon fibers are configured by a linear fiber. The longitudinal direction of the carbon fibers is oriented along the surface. The continuous body (structure) having a uniform composition as referred to herein means that the composition of the carbon fibers and the matrix is uniform in an arbitrary position of the C/C composite material, and a C/C composite material molded body containing a matrix layer composed of a matrix formed on a bonding interface between carbon fiber cloth sheets or filament and a gap layer formed without being filled with a bonding agent is not a continuous body having a uniform composition. In the meantime, a C/C composite material molded body obtained by bonding the C/C composite material molded body according to an embodiment of the present invention to another C/C composite material is included in the C/C composite material molded body of the present invention.

As described above, by providing the flange part 100T in the lower end of the cylindrical part 100a, a curved surface constituting the cylindrical surface and a ring-like plane are continuously integrally formed adjoining to each other. Here, as shown in Fig. 1C, the thin piece bodies 3 are also oriented along a second surface 100o that is an outer surface and a first surface 100i that is an inner surface in an boundary region 100R between the curved surface constituting the cylindrical surface and the ring-like plane, thereby constituting a continuous body having a uniform composition, so that extremely high strength is revealed. In the boundary region 100R, the boundaries of the thin piece bodies 3 are dispersed, thereby forming a uniform molded body. The state where the boundaries of the thin piece bodies are dispersed to form a uniform molded body as referred to herein means a state where there is neither a bonding layer formed by sticking nor a break for smoothly connecting the surfaces to each other such that no wrinkle is formed. This C/C composite material molded body has a shell-like structure configured by a continuous body having a uniform composition as a whole.

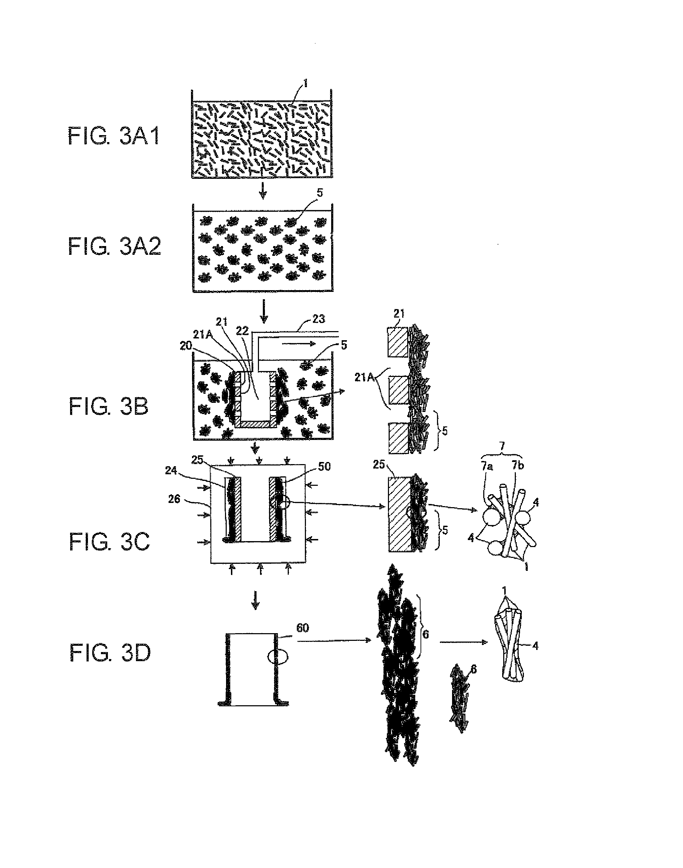

As shown in Fig. 3B, the molded body according to an embodiment of the present invention is obtained by filtering flocks using a die 20 having a porous die face 21 on a side surface and a bottom surface thereof. The flocks are laminated as a continuous layer in a surface direction of the porous die face 21. In this way, the thin piece bodies 3 are configured in the first surface 100i along an outer wall of the die 20 and the second surface 100o opposing to the first surface 100i, to form a laminate of thin piece bodies configured by the cylindrical part 100a having the flange part 100T, whereby a desired shape can be obtained.

In the molded body according to an embodiment of the present invention, the carbonaceous matrix 2 is filled and constituted so as to intervene between the carbon fibers 1 constituting the thin piece bodies 3, thereby fixing the carbon fibers each other. Furthermore, since the thin piece bodies 3 are laminated in such a manner that fallen leaves are piled up at random, even in the C/C composite material molded body configured by a three-dimensional curved surface or a combination of plural surfaces according to an embodiment of the present invention, the ends of the thin piece bodies are dispersed in many places of the inside of the C/C composite material molded body. According to this, a defect (boundary of the thin piece body) which is structurally weak, thereby causing separation or formation of a crack is finely dispersed.

In the meantime, in the case where a large defect is present in one place, this large defect becomes a notch, thereby easily causing a lowering of the strength. On the other hand, when a defective portion is finely dispersed as in an embodiment of the present invention, a stress to be applied to the defective portion can be dispersed. For that reason, a C/C composite material molded body which is apparently homogenous and free from a defect can be obtained. Since the C/C composite material molded body according to an embodiment of the present invention has such a structure, a C/C composite material molded body which is high in heat resistance and high in strength even at a high temperature can be obtained.

Here, in the boundary region 100R between planes orthogonal to each other, the thin piece bodies 3 are also oriented along the first surface 100i and the second surface 100o_{,} thereby constituting a uniform continuous surface. Also, in this boundary region 100R, the boundaries of the thin piece bodies 3 are dispersed, thereby revealing a uniform and high density. For that reason, a molded body having extremely high strength is formed. In this way, the first surface 100i that is an inner surface and the second surface 100o that is an outer surface, each of which constitutes the thin piece bodies 3, are substantially parallel to each other, thereby constituting a shell-like structure configured by a continuous body having a uniform composition as a whole.

An average major axis diameter of the thin piece body is preferably from 1 to 10 mm, and more preferably from 2 to 5 mm. When the average major axis diameter of the thin piece body is less than 1.0 mm, since the size of the corresponding flock piece becomes small, the hydraulic resistance tends to become large at the time of sheet-forming, and a thick-walled C/C composite material molded body is hardly obtainable. On the other hand, when the average major axis diameter of the thin piece body exceeds 10 mm, in laminating a flock serving as a base of the thin piece body in a manufacturing step as described later, in view of the fact that a fiber and a binder are different in easiness of aggregation from each other, segregation is easy to occur in a central part and a peripheral part of the flock, and therefore, a binder component in the inside of the thin piece body is also easy to cause segregation. Also, when the average major axis diameter of the thin piece body exceeds 10 mm, even when the binder is melted in subsequent molding and curing, the thin piece body cannot sufficiently flow, whereby the segregation is hardly relieved. As a result, a portion which is thin in the binder is formed, whereby there is a concern that the strength of the molded body is lowered.

An average thickness of the thin piece body is preferably from 0.05 to 1.0 mm, and more preferably from 0.1 to 0.5 mm. When the average thickness of the thin piece body is less than 0.05 mm, the size of the corresponding flock becomes large, the hydraulic resistance tends to become large, and a thick-walled C/C composite material molded body is hardly obtainable. When the average thickness of the thin piece body exceeds 1.0 mm, a void is formed in an end of the thin piece body, and stress concentration is easily generated in the surroundings of the void, whereby there is a concern that the strength of the molded body is lowered.

In this way, the longitudinal direction of the carbon fibers 1 is oriented in the surface direction of the C/C composite material molded body 100 itself, and the boundaries of the thin piece bodies 3 are dispersed. In consequence, a molded body which is uniform, hardly causes stress concentration and is small in strain is obtainable, and even at a high temperature, a molded body which is uniform and hardly causes stress concentration is similarly obtainable. Thus, a three-dimensional C/C composite material molded body with high heat resistance and high strength can be obtained.

In the meantime, the term "oriented" as referred to herein means a state where the direction of the fibers leans to a specified direction but does not refer to a state where all of the fibers directs a same direction.

As described later, the C/C composite material molded body according to an embodiment of the present invention is formed by aggregating carbon fibers and a binder in a liquid to form flocks and laminating (sheet-forming) the flocks. The flock as referred to herein means an aggregate in which randomly oriented carbon fibers and a binder are uniformly dispersed. In an embodiment of the present invention, the carbon fibers 1 are composed of a linear fibers. In view of the fact that the carbon fibers 1 are composed of a linear fiber, in filtering the flocks using a die in a laminating step (at the time of sheet-forming) of flocks as described later, a linear carbon fiber pierces the flock of a lower layer, which is already formed on the surface of the die, and is joined in a thickness direction. Therefore, a joining strength in a vertical direction (thickness direction) to the surface direction of the molded body is easily obtainable. The "linear fiber" as referred to in an embodiment of the present invention means a fiber which does not substantially have a bending part and is preferably an acicular fiber. In the case of using carbon fibers which hardly become a linear fiber, such as carbon fibers having a long fiber length and soft carbon fibers, such a carbon fiber hardly pierces the already formed thin piece body, and the longitudinal direction of almost all of the fibers is oriented along the surface direction of the molded body. Therefore, the amount of the carbon fibers taking part in joining in the thickness direction becomes small, so that the joining strength in the thickness direction is hardly obtainable.

It is desirable that the molded body according to an embodiment of the present invention contains a carbon fiber component connecting the thin piece bodies adjoining in the laminating direction of the thin piece body (thickness direction of the molded body) to each other. Also, it is desirable that an orienting component in the thickness direction of the carbon fibers 1 is continuously present in the thickness direction of the molded body. As described above, flocks containing a linear fiber are laminated in such a manner that the linear carbon fiber pierces the already formed flock, and hence, the orienting component in the thickness direction is also continuously formed at a boundary between the flocks. According to this, a hardly separable C/C composite material molded body which does not have an interface in a vertical direction to the thickness direction of the molded body can be obtained.

An average fiber length of the carbon fibers is desirably less than 1.0 mm. When the average fiber length of the carbon fibers is 1.0 mm or more, fibers get tangled together and repel each other at the time of sheet-forming, so that a sheet-formed body with a high bulk density is hardly obtainable. In the case where the bulk density of a laminate of flocks is low, when compression molding is performed using an autoclave or the like, the larger a difference in the bulk density before and after the compression, the higher a compressibility is, a wrinkle is generated in a compression process, and in particular, a corner part is easily lined with wrinkles, and a defect increases. When such a defect increases, a portion with low strength is generated in the corner part. When the average fiber length of the carbon fibers is less than 1.0 mm, a void of the sheet-formed body is easily filled, and the carbon fibers become linear. Therefore, a sheet-formed body with a higher bulk density can be obtained, and hence, the compressibility can be made low in undergoing compression molding using an autoclave. According to this, the generation of a wrinkle in the corner part or the like can be suppressed, whereby a C/C composite material molded body with a less defect can be obtained.

Furthermore, when the average fiber length of the carbon fibers is 1.0 mm or more, the carbon fibers are easily bent, and the longitudinal direction of the carbon fibers is oriented especially in the surface direction of the C/C composite material molded body at the time of sheet-forming. For that reason, tangling among fibers in the thickness direction is few, and separation is easy to occur. Also, in the case of using long fibers and sheet-forming them, a thick sheet-formed body having a low carbon fiber density as from 0.1 to 0.2 g/cm³ is obtainable. However, in the case of undergoing compression molding using an autoclave or the like for the purpose of increasing the density, not only a very thick sheet-formed body is necessary, but the compressibility is high. Therefore, it is difficult to control the shape in a site with a high curvature.

On the other hand, when the average fiber length of the carbon fibers is less than 1.0 mm, the carbon fibers are easy to become a linear fiber and easy to pierce the already formed flock of a lower layer at the time of sheet-forming, and the joining strength in the thickness direction of the molded body is easily obtainable.

The average fiber length of the carbon fibers is desirably 0.05 mm or more, and more desirably in the range of 0.05 mm or more and less than 0.5 mm. When the average fiber length of the carbon fibers is less than 0.5 mm, not only the strength in the thickness direction of the carbon fiber-reinforced carbon composite material molded body can be more increased, but since short fibers are easily filled in a high density, the density especially at the time of laminating flocks can be increased, and the compressibility at the time of molding can be increased. When the average fiber length of the carbon fibers is less than 0.05 mm, a sufficient bonding force between the fiber and the binder is not obtainable, and the fibers are easily pulled out, whereby there is a concern that a molded body with high strength is not obtainable.

Incidentally, in the case of using merely short fibers of, for example, from 1 to 10 mm and sheet-forming them using a die with a fine texture, since tangling of the fibers becomes few, a sheet-formed body having a high density is obtainable. However, since passing resistance of a liquid (water) for dispersing the carbon fibers becomes large at a stage in which a thin sheet-formed body is formed, it becomes difficult to undergo the sheet formation, and it is difficult to obtain a thick sheet-formed body with a high density. On the other hand, in an embodiment of the present invention, by forming flocks, a thick sheet-formed body with a high density is formed by effectively laminating thin piece bodies without causing clogging and then compressed, whereby a C/C composite material molded body configured by a thick and uniform continuous body can be obtained with respect to any surface even including a three-dimensional curved surface and a combination of plural surfaces.

An average fiber diameter of the carbon fibers is preferably from 1 to 20 µm. Also, an aspect ratio of the carbon fibers is preferably from 10 to 1,000. When the average fiber diameter and the aspect ratio of the carbon fibers fail within the foregoing ranges, respectively, the fiber diameter can be made sufficiently thin relative to the fiber length, and the fibers are hardly drawn out from the matrix, and hence, high strength is obtainable.

As the carbon fibers, any of a pitch based carbon fiber or a PAN based carbon fiber can be suitably used. Since the PAN based carbon fiber is low in elastic modulus as compared with the pitch based carbon fiber, it can be suitably used for applications requiring flexibility, for example, a crucible for single crystal pull-up apparatus, a heat insulating cylinder, a crucible receptacle, a heater, etc. Since the pitch based carbon fiber is high in elastic modulus as compared with the PAN based carbon fiber, it can be suitably used for structural members of machine parts in which it is intended to suppress flexion, such as a liquid crystal support plate and a conveying arm.

The molded body according to an embodiment of the present invention preferably has a bulk density of from 1.2 g/cm³ to 1.8 g/cm³. When the bulk density of the molded body is 1.2 g/cm³ or more, since a void of the C/C composite material is few, joining among the carbon fibers by the matrix becomes dense, and the carbon fibers hardly leave. For that reason, a dense C/C composite material molded body with higher strength can be obtained. When the bulk density of the molded body exceeds 1.8 *g*/cm³, a bubble is easily generated due to degreasing or a gas generated at the time of calcination, whereby a uniform layer is hardly obtainable.

In the molded body according to an embodiment of the present invention, even in the case of a curved C/C composite material having a thickness of 20 mm or more, a C/C composite material with high strength can be easily formed. Since flocks containing carbon fibers and a binder are once formed and then deposited in a die by means of a sheet-forming method, thereby molding a preliminarily molded body that is a laminate of flocks, a thick-walled preliminarily molded body is easily obtainable, and a C/C composite material molded body having a wall thickness of 20 mm or more is easily obtainable.

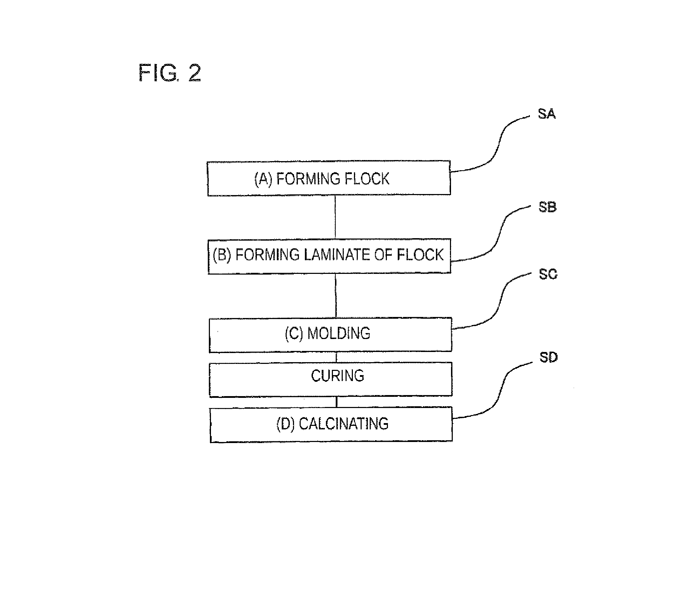

The manufacturing method of the C/C composite material molded body according to an embodiment of the present invention is hereunder described. Fig. 2 is a flow chart of manufacturing steps of the molded body according to an embodiment of the present invention; and Figs. 3A1 to 3D are outline views showing a manufacturing method of the molded body.

1. Step (A): Flock forming step SA

First of all, as shown in Fig. 2 and Figs. 3A1 to 3A2, the carbon fibers 1 and a binder that is a precursor component of a carbonaceous matrix are suspended in a liquid, and thereafter, an aggregating agent is added to aggregate the carbon fibers 1 and the binder, thereby forming flocks 5. As shown in Fig. 3A1, the carbon fibers 1 are first dispersed in a liquid to form a slurry, and as shown in Fig. 3A2, the slurry is then aggregated with a lapse of time, thereby forming the flocks 5.

2. Step (B): Step SB of forming a laminate of flocks (first molded body)

Subsequently, as shown in of Fig. 2 and Fig. 3B, the liquid having the flocks 5 formed therein is filtered by the die 20 having the porous die face 21. The porous die face 21 has a large number of openings 21A on a side surface thereof. According to this, the flocks 5 are laminated on the surface of the porous die face 21, thereby forming a laminate 50 of flocks.

Different from a conventional technique of direct filtration (sheet-forming) of a slurry having carbon fibers suspended therein, the manufacturing method according to an embodiment of the present invention is characterized in that the carbon fibers are once aggregated together with the binder to form flocks, which are then filtered (formed). According to this, even when lamination of the flocks 5 onto the porous die face 21 proceeds, the liquid is able to permeate between the flocks 5, and therefore, the thick laminate 50 of flocks which hardly blocks the permeation of the liquid is easily obtainable. Also, as shown an enlarged view of Fig. 3C, even in the case of making the average fiber length of the carbon fibers 1 smaller than the openings 21A of the porous die face 21 for the purpose of making the passing resistance of water small, the flocks 5 can be formed larger than the opening 21A. In consequence, the laminate 50 of flocks can be formed without allowing the carbon fibers 1 to pass through the opening 21A at the time of filtration.

3. Step (C): Step SC of molding a laminate of thin piece body precursor (second molded body)

Subsequently, as Step (C), as shown Fig. 2 and Fig. 3C, the laminate 50 of flocks is pressurized. According to this, the longitudinal direction of the carbon fibers I is oriented in the surface direction of the porous die face 21. Then, the flocks 5 are converted into a thin piece, thereby forming a thin piece body precursor 6 as shown in Fig. 3D. In this way, a laminate 60 of thin piece body precursor is formed.

4. Step (D): Calcination step SD

Then, as Step (D), as shown in Fig. 2 and Fig. 3D, the laminate 60 of thin piece body precursor is calcined. According to this, a binder 4 is carbonized to form the carbonaceous matrix 2 as shown in Fig. 1E, whereby the laminate 60 of thin piece body precursor becomes the thin piece body 3. In this way, a laminate of the thin piece bodies 3, namely the molded body 100 according to an embodiment of the present invention, is obtained.

Next, each of the steps is hereunder described in more detail.

[Regulation of carbon fiber]

It is preferable that the carbon fibers are regulated so as to agree with the molded body according to an embodiment of the present invention. On the surface of a carbon fiber for a carbon fiber-reinforced plastic (hereinafter also referred to as "CFRP") which is used for generally widely circulated fishing rods or aircraft parts or the like, a coating film of a sizing agent or the like is formed, and therefore, such a carbon fiber is hardly dispersed in water at the time of sheet-forming. For that reason, a carbon fiber which is free from a coating film of a sizing agent or the like is chosen, or the sizing agent or the like is removed by thermally treating such a carbon fiber in an inert gas atmosphere or a reducing atmosphere. Incidentally, scraps generated in a process of manufacture of CFRP may also be used. Such a coating film can be removed by means of thermal treatment at 500 °C or higher. Subsequently, it is preferable that the carbon fiber is regulated so as to have an average fiber length of less than 1.0 mm. When the average fiber length of the carbon fiber is less than 1.0 mm, as described above, the bulk density can be increased at the stage of a laminate of flocks (sheet-formed body); the generation of a wrinkle at the time of molding can be suppressed; the generation of a portion having weak strength can be suppressed; joining strength in the thickness direction of the molded body is obtainable; and a hardly separable molded body with high strength is obtainable. The carbon fiber having an average fiber length of less than 1.0 mm can be obtained by pulverizing commercially available carbon fibers or scraps of cloths, strands or the like generated in a process of manufacture of CFRP. By pulverizing scraps of cloths, strands or the like of carbon fibers, a raw material of carbon fiber having an average fiber length of less than 1.0 mm, which does not leave traces of cloths, strands or the like and which is easily utilized in the invention, can be obtained. Incidentally, pulverization can be achieved by means of dispersion in water and uniform pulverization using a mixer. Here, for forming the atmosphere of removing the sizing agent, a reducing gas such as a hydrocarbon gas generated from an organic material and hydrogen, or an inert gas such as a nitrogen gas and an Ar gas can also be applied.

[Flock forming step (A)]

For forming flocks, it is desirable to use water as the liquid. This is because a large amount of the liquid is used, and therefore, not only water can be safely used as compared with organic solvents, but the treatment of a waste liquid is easy.

As the binder including a precursor component of the carbonaceous matrix (hereinafter also referred to as a "first binder"), any material is useful so far as it is insoluble in the foregoing liquid in which the carbon fibers are suspended and is carbonized. The first binder is preferably powdery and preferably has a particle diameter of from 3 to 100 µm. So far as the first binder is powdery, it is uniformly dispersed in voids among the carbon fibers and is able to make it difficult to cause segregation. For that reason, even in the case where the first binder is subsequently melted and attaches onto the carbon fiber surfaces, a C/C composite material with high strength can be obtained without forming large voids. As the first binder, for example, at least one selected from a pitch and thermosetting resins such as phenol resins, furan resins and imide resins can be suitably utilized. As the phenol resin, for example, Bell Pearl (registered trademark) S890, manufactured by Air Water Inc. can be suitably utilized. Bell Pearl is a powdery phenol resin, and a hydrophobic coating film is formed on the surface thereof. Thus, Bell Pearl keeps the powdery state without being dissolved even in water, so that it is able to aggregate together with the carbon fibers.

An addition amount of the first binder is preferably from 50 to 200 parts by weight based on 100 parts by weight of the carbon fiber. When the addition amount of the first binder is less than 50 parts by weight, the carbon fibers cannot be sufficiently condensed, whereas when it exceeds 200 parts by weight, a bubble is easily generated due to degreasing or a gas generated at the time of calcination. In both of these cases, there is caused a lowering of the strength.

As the aggregating agent which is used in an embodiment of the present invention, any material is useful so far as it is able to aggregate the carbon fibers and the binder while utilizing a change of electric charges. Preferably, a material capable of regulating a ζ-potential so as to fall within ±10 mV is desirable. For example, an inorganic aggregating agent material, an organic polymer aggregating agent and the like can be utilized. Specifically, Percol 292 (registered trademark, manufactured by Allied Colloid Company) that is an organic polymer aggregating agent and the like can be suitably utilized. The organic polymer aggregating agent is preferable because it has a large molecular weight, has a crosslinking action and is able to obtain a large flock. When the flock is formed, the state of a slurry colored black with the carbon fibers changes into a state of a mixed liquid in which the black flock floats in a transparent liquid. The organic polymer aggregating agent can be preferably used in view of the fact that it has a large molecular weight, has a crosslinking action and is able to obtain a large flock.

An addition amount of the aggregating agent is preferably from 0.05 to 5.0 parts by weight based on 100 parts by weight of the carbon fibers. When the addition amount of the aggregating agent falls within the foregoing range, a favorable flock which hardly collapses can be formed.

Also, although a size of the opening of the porous die face is not particularly limited, it is preferably from 0.5 to 10 mm, and more preferably from 1 to 3 mm. When the size of the opening of the porous die face is less than 0.5 mm, the carbon fibers are easy to cause clogging, whereby there is a concern that the passing resistance of water becomes large. When the size of the opening of the porous die face exceeds 1.0 mm, since a suction force obtained by multiply an opening area by a negative pressure is generated in the opening, there may be the case where even a flock having such a size that it does not originally pass is sucked and allowed to pass. The size of the flock is required to be equal to or more than the size of the opening of the porous die face used for filtration. Since the size of the flock has a distribution, when a flock having a large diameter is trapped by the die face, deposition of flocks on the porous die face starts. When an average diameter of the flock is largely lower than the size of the opening of the porous die face, the majority of flocks pass through the die face, so that the flocks cannot deposit on the die face. The average diameter of the flock in the mixed liquid is preferably from 0.5 to 10 mm, and more preferably from 1 to 5 mm. The size of the flock can be regulated by an amount of the aggregating agent, aggregation time or strength of stirring.

It is preferable that a second binder is further added in the liquid for forming a flock. Since the foregoing first binder component is powdery at a sheet-forming stage, it is not able to keep the shape of the laminate of flocks (sheet-formed body). The second binder is a component which is added for the purpose of keeping the shape of the laminate of flocks (sheet-formed body) to be obtained subsequently until a subsequent calcination step. As the second binder, any material may be used so far as it is able to keep the shape of the laminate of flocks. Any material having an action to physically couple the carbon fibers and the first binder, and also the carbon fibers each other at a stage of forming the laminate of flocks may be used, and examples thereof include viscous liquids and organic fibers. As the viscous liquid, starch, latexes and the like can be suitably utilized. When the latex is mixed with water, it becomes cloudy to form a suspension. A droplet of the finely dispersed latex has an action to couple the carbon fibers with the first binder by an adhesive action. As the organic fiber, pulp or the like can be suitably utilized. The pulp has a good affinity with water and tangles with the carbon fibers to reveal an action to couple the carbon fibers with the first binder. In the case where a viscous liquid is used as the second binder, for example, as shown in Fig. 3C, in view of the fact that a second binder 7a intervenes between the carbon fiber 1 and the first binder 4, and a second binder 7b intervenes between the carbon fibers 1, the shape of the laminate 50 of flocks is kept.

Incidentally, in forming the flocks, the addition order of the foregoing carbon fibers, first binder, aggregating agent and second binder is not particularly limited, and they may be added in the liquid simultaneously or successively. However, from the viewpoint of forming the flocks uniformly and stably, it is preferable to undergo the preparation in the following order.
(a) The carbon fibers are added in water and dispersed with stirring. When stirring is too strong, bubbles are formed, and hence, such is not preferable. As stirring means, a propeller shaft type, a paddle type or the like can be used. A stirring time of the carbon fibers is preferably about 3 minutes.
(b) Subsequently, the first binder is added, and stirring is continued until the first binder is dispersed. A stirring time is preferably from 0.5 to 5 minutes.
(c) Subsequently, the second binder is added, and stirring is continued until the second binder is dispersed. A stirring time is preferably from 0.5 to 5 minutes.
(d) Finally, the aggregating agent is added. When stirring is few, the aggregating agent is not mixed, whereas when stirring is excessive, the formed flocks are broken. A stirring time is regulated while confirming a degree of formation of flocks. The stirring time is preferably from 20 to 30 seconds.

[Forming step (B) of laminate of flocks (first molded body)]

The die 20 is dipped in the liquid containing the thus formed flocks 5. As shown in Fig. 3B, the die 20 is provided with the porous die face 21 having a cylindrical shape and a vacuum chamber 22. The porous die face 21 is provided with the openings 21A, and flocks are laminated only on the porous die face 21. The vacuum chamber 22 is connected to a suction pump (not shown) by a conduit 23. In consequence, when the suction pump is actuated, air within the vacuum chamber 22 is discharged, thereby presenting a vacuum state. Then, the flocks 5 are suctioned on the side of the die 20. Since the size of the flock 5 is larger than the size of the opening 21A, the flocks 5 do not pass through the openings 21A but are laminated as a continuous layer on the surface of the porous dye surface 21 in the surface direction of the porous die face. On that occasion, the flocks 5 are laminated so as to pierce the already formed laminate. The laminated flocks 5 become slightly flat from a spherical shape due to an influence of the suction force, and the longitudinal direction of the carbon fibers 1 within the flocks is oriented in the surface direction of the porous die face 21. On the other hand, the liquid passes through the openings 21A and is discharged out through the conduit. In this way, the laminate 50 of flocks (first molded body) can be formed.

As the porous die face 21, any material having plural openings through which the liquid is able to pass is useful, and examples thereof include nets, punching metals, woven fabrics and nonwoven fabrics.

Incidentally, although the shape of the die is described later, a plane, a combination of plural planes, a three-dimensional curved surface, a combination of curved surfaces, a cylinder having a flange, a cone, a bottomed body, a circular cylinder and so on can be properly chosen.

Also, at the time of suction filtration, any material may be used for undergoing the pressure reduction. In addition to air, other liquid can be suctioned together, and hence, a self-suction type centrifugal pump, an aspirator or the like can be suitably utilized.

Incidentally, as a method of filtration, in addition to the foregoing suction filtration, pressure filtration, centrifugal filtration or other method may be adopted. The pressure filtration is, for example, a method in which the outer surface side of the porous die face is pressurized by a pressurized gas to laminate flocks on the outer surface of the porous die face, thereby forming a laminate of flocks. The centrifugal filtration is, for example, a method in which a flock-containing mixed liquid is supplied into the inside of a die of a rotary body having a porous die face placed on the inner surface thereof, the rotary body is rotated to laminate flocks on the inner surface of the porous die face, thereby forming a laminate of flocks.

[Drying step]

Subsequently, in order to remove water remaining in the laminate of flocks obtained in the preceding step, it is preferable to dry the laminate together with the die. Drying is preferably performed at 40 °C or higher for the purpose of removing water. Also, in order to prevent melting and curing of the first binder, it is preferable to perform drying at a temperature of not higher than a melting temperature of the first binder. For example, in the case of using Bell Pearl (registered trademark) as the first binder, taking into consideration the fact that the hydrophobic coating film is melted at about 70 °C, drying is performed at not higher than 60 °C while ventilating air, whereby water can be easily removed.

[Pressurizing step] (Molding of laminate of thin piece body precursor (second molded body))

As shown in Fig. 3C, the laminate 50 of flocks is covered by a sealing film 24 and molded by applying heat and pressure using an autoclave 26, thereby obtaining a second molded body. First all, air within the sealing film 24 is suctioned to draw a vacuum, and a pressure is then applied. A molding pressure is preferably 1 MPa or more. When the molding pressure is 1 MPa or more, a molded body with a high density can be obtained. Though there is no particular upper limit in the molding pressure, since the first binder is softened by applying heat, when a pressure of 10 MPa is applied, a sufficient density of the molded body is obtainable. At that time, it is preferable to undergo molding while supporting the both sides (inner side or outer side) of the die 20 of the laminate 50 of flocks by a support material 25. Since there is a concern that the laminate of flocks is softened and deformed by heating, when the laminate is supported by the support material 25, deformation can be prevented from occurring. Different from that of the die 20 used in the forming step (B) of the laminate of flocks (first molded body), the support material 25 as used herein is one not having a porous die face but having a smooth surface. In the case where the molded body has a shape close to a plane, a pressurizing method by means of uniaxial molding can be utilized as a molding method. However, this method can be utilized only for a limited structure in which an upper die and a lower die are constituted on the both sides of a cavity.

[Curing step]

Since the first binder is a thermosetting resin, it is preferable that after sufficiently increasing the pressure in the foregoing pressure molding step, the molded body is heated, thereby melting and curing the thermosetting resin contained in the flocks. According to this, the shape can be fixed in such a manner that the laminate 60 of a thin piece body precursor (second molded body) is not deformed. It is necessary to increase a curing temperature to the curing temperature of the thermosetting resin or higher. For example, in general, curing can be performed at 150 °C or higher. The higher the temperature, the more advanced the curing is. In the case where the foregoing molding step is performed in an autoclave or other cases, so far as heating can be sufficiently performed in the molding step, the curing step can also be performed simultaneously with the molding step. Although there is no particular upper limit in the curing temperature, when a temperature of 200 °C is applied, curing can be sufficiently achieved.

[Degreasing step]

In order to volatilize an organic component in the inside of the laminate 60 of a thin piece body precursor (second molded body), it is preferable to perform degreasing prior to the calcination step. By way of this degreasing step, the first binder is carbonized, and the majority of the second binder is separated and vaporized. For that reason, the carbide derived from the first binder component is a material having a coupling action after the degreasing step. Any degree of temperature is adaptable for a temperature of the degreasing. In the case where pitch impregnation and resin impregnation are performed after the degreasing step, it is necessary to form pores, and hence, it is preferable to perform the degreasing at 500 °C or higher. When the temperature is 500 °C or higher, carbonization of the resin sufficiently proceeds, and pores having a sufficiently large size such that the resin or pitch is impregnated therein in the subsequent impregnation step can be formed. Although an upper limit of the degreasing temperature is not particularly limited so far as it is not higher than a temperature of the subsequent calcination temperature, by placing the laminate at a high temperature of 1,000 °C, the majority of degreasing can be completed. In order to prevent oxidation of the carbon fibers or binder from occurring, it is preferable to perform the degreasing in a reducing atmosphere. In addition to the reducing atmosphere using a hydrocarbon gas generated from an organic material or hydrogen, an inert gas atmosphere using a nitrogen gas, an Ar gas or the like can also be applied.

[Impregnation step]

It is preferable to impregnate a resin, a pitch or the like in the inside of the pores of the laminate 60 of a thin piece body precursor (second molded body) after the degreasing, thereby realizing a high density. The laminate 60 of a thin piece body precursor (second molded body) after the degreasing is placed in the autoclave 26, and after drawing a vacuum, a liquid resin or pitch is introduced into the autoclave 26 and dipped, followed by applying a pressure. The liquid resin may be a solution of the resin in water or an organic solvent, or may be a melted material obtained by applying heat. In the case of a solution, even when the use is repeated, polymerization hardly proceeds, so that the solution can be stably used. In the case of a pitch, the pitch is used after being converted into a liquid upon heating the autoclave at a melting point or higher.

After completion of the impregnation, similar to the foregoing degreasing step, degreasing is performed, whereby a molded body with a higher density can be obtained.

[Calcination step (D)]

By further applying heat to the laminate of a thin piece body precursor (second molded body) to perform calcination, the first binder is thoroughly carbonized, thereby forming a carbonaceous matrix. According to this, the thin piece body precursor becomes a thin piece body, whereby the C/C composite material molded body 100 according to an embodiment of the present invention which is constituted of a laminate of thin piece bodies can be obtained.

In the calcination step, the support material thermally expands with an increase of the temperature, and the laminate 60 of a thin piece body precursor thermally shrinks. In order to avoid a stress to be caused due to a difference in thermal expansion generated in the calcination step, it is preferable that the support material 25 is removed from the laminate 60 of a thin piece body precursor and heated in a non-oxidizing atmosphere within a calcination furnace. A desired temperature of the calcination step is from 1,500 to 2,800 °C. When the calcination temperature is 1,500 °C or higher, a functional group in the C/C composite material, such as hydrogen, can be sufficiently removed. When a functional group such as hydrogen remains, a hydrocarbon gas or the like is generated at the time of using the C/C composite material molded body. When a molded body which is not calcined at a calcination temperature of 1,500 °C or higher is used in a semiconductor manufacturing apparatus or the like, there is a concern that such a hydrocarbon gas is incorporated into a semiconductor, thereby lowering the purity. When the calcination temperature is not higher than 2,800 °C, the progress of crystallization of the C/C composite material can be suppressed, and the strength can be kept. A more desired range of the calcination temperature is from 1,800 to 2,500 °C. It is preferable that the calcination is performed at a heating rate of about 500 °C/hour.

Incidentally, in order to increase the density, the impregnation step and the degreasing step may be repeated plural times prior to the calcination step.

According to an embodiment of the present invention, by forming the shape of the porous die face 21 into a shape along the shape of the desired molded body, molded bodies having various three-dimensional shapes in addition to the foregoing shape can be manufactured by means of integral molding.

Then, with respect to the C/C composite material molded body according to an embodiment of the present invention, by way of the drying step, pressurizing step, degreasing step, impregnation step and calcination step, the C/C composite material molded body 100 composed of a cylinder having a flange part as shown in Figs. 1A and 1B can be obtained. In this C/C composite material molded body 100, the thin piece bodies are also oriented along the first and second surfaces 100i and 100o in a boundary part, namely a joint part between the flange part and the cylindrical part, the boundaries of the thin piece bodies are dispersed, and even in the surface-to-surface joint part, a molded body which continuously has a uniform composition is formed. In consequence, a thick-walled C/C composite material molded body with high density and high strength is obtainable.

(Embodiment 2)

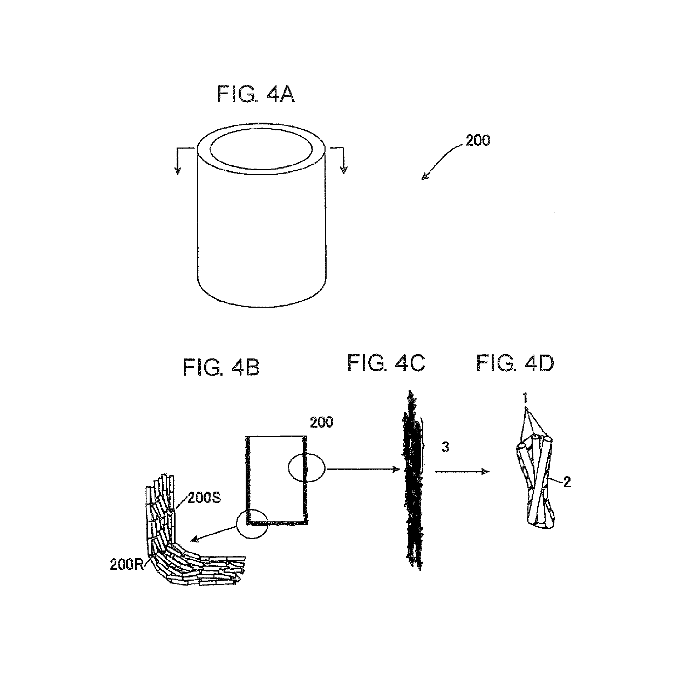

A molded body according to Embodiment 2 of the present invention is described on the basis of Figs. 4A to 4D. Fig. 4A is a perspective view of a molded body of Embodiment 2; Fig. 4B is a sectional view thereof; Fig. 4C is an enlarged view of a part thereof; and Fig. 4D is a more enlarged view thereof.

A C/C composite material molded body 200 of Embodiment 2 has a bottom surface and is the same as the molded body 100 of Embodiment 1, except for that it has a bottom surface. The C/C composite material molded body 200 of Embodiment 2 is configured by a bottom surface and a cylinder.

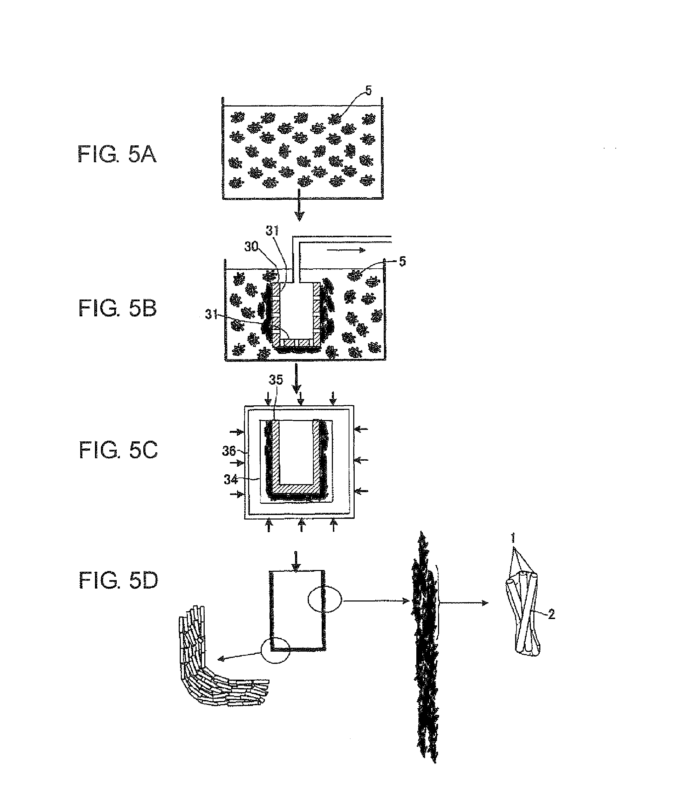

In order to manufacture the C/C composite material molded body 200 of Embodiment 2, as shown in Fig. 5B, the flocks 5 are filtered using a die 30 having a porous die face 31 on each of a side surface and a bottom surface at the time of forming a laminate 50 of flocks. The flocks 5 are laminated as a layer continuing in a surface direction of the porous die face 31. Also, as shown in Fig. 5C, a support material 35 in a pressurizing step is made bottomed. Other points are the same as those in the manufacturing method of Embodiment 1, the surface is covered by a sealing film, and the resultant is placed in an autoclave 36 and pressurized while applying heat of 150 °C. According to this, the C/C composite material molded body 200 shown in Figs. 4A and 4B is obtained. In the resulting C/C composite material molded body 200, the thin piece bodies are also randomly oriented along a surface 200S of the molded body 200 in a boundary region between the bottom surface and the side surface. Then, a continuous body which is uniform along the surface is formed. For example, in the enlarged view of Fig. 4B, the carbon fibers and the matrix form a continuous form in such a manner that the thin piece bodies are randomly laminated in the boundary region connecting the bottom surface and the side surface to each other while gradually changing an angle.

In this way, not only a part of the carbon fibers contains a component of connecting the thin piece bodies adjoining in the laminating direction of the thin piece body to each other, but the thin piece bodies are disposed in such a manner that ends of the thin piece bodies adjoining in the laminating direction of the thin piece body to each other are deviated in the laminating direction, and hence, the boundaries of the thin piece bodies are dispersed, thereby forming a uniform molded body.

In this way, in a boundary region 200R between the bottom surface and the side surface, the thin piece bodies 3 are also oriented along the surface 200S to constitute a uniform continuous surface, thereby revealing extremely high strength. Also, in this boundary region 200R, the boundaries of the thin piece bodies 3 are dispersed, thereby forming a uniform molded body. The uniform state formed when the boundaries of the thin piece bodies are dispersed means a state where there is neither a bonding layer formed by sticking nor a break for smoothly connecting surfaces to each other such that no wrinkle is formed. Similar to Embodiment 1, according to this embodiment, it is also possible to obtain a C/C composite material molded body with thigh strength and high density.

(Embodiment 3)

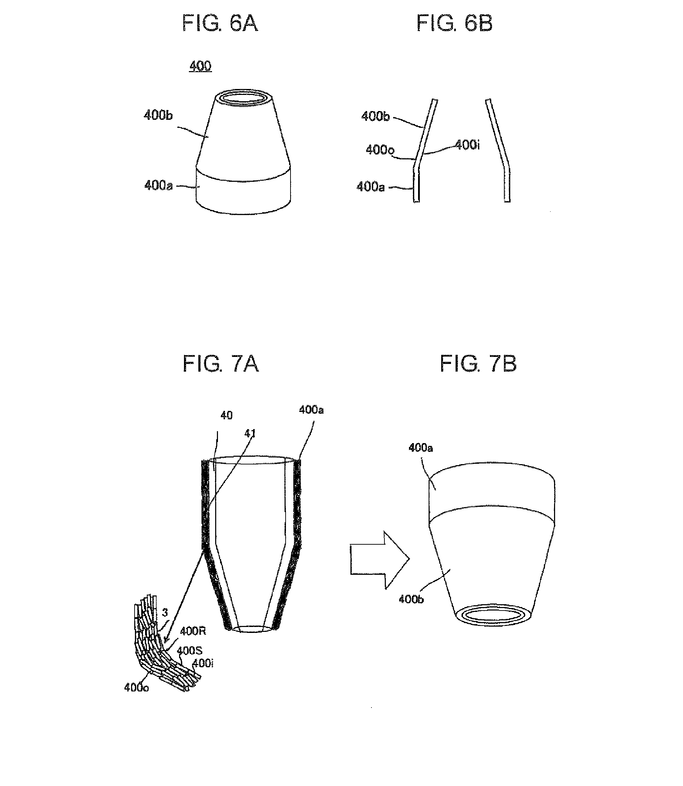

Next, a molded body according to Embodiment 3 of the present invention is described on the basis of Figs. 6A to 7B. Fig. 6A is a perspective view of a C/C composite material molded body of Embodiment 3, and Fig. 6B is a sectional view thereof; and Figs. 7A and 7B are each a diagrammatic view showing manufacturing steps of a C/C composite material molded body of Embodiment 3. Incidentally in Figs. 6A to 7B, for the purpose of viewing the state of the both upper and lower surfaces, views in which the upper and lower ends are reversed, respectively are used.

A C/C composite material molded body 400 of Embodiment 3 is the same as the C/C composite material molded body 100 of Embodiment 100, except for that a truncated conical cylindrical part 400b is provided in an end of the lower side of a cylindrical part 400a. In this way, in view of the fact that the truncated conical cylindrical part 400b is provided, a curved surface constituting the cylindrical surface and a curved surface constituting the truncated cylindrical part are integrally formed adjoiningly in a continuous manner. Here, the thin piece bodies 3 are also oriented along a surface 400S in a boundary region 400R between the curved surface constituting the cylindrical surface and the truncated conical cylindrical part, thereby constituting a continuous body having a uniform composition. Then, since a uniform continuous surface with high strength is constituted, extremely high strength is revealed. Also, in this boundary region 400R, boundaries of the thin piece bodies 3 are dispersed, thereby forming a uniform molded body.

In manufacturing this C/C composite molded body 400, the same procedures as those in the foregoing Embodiment 1 are followed, except for using a die 40 having an outer surface having a columnar shape and a conical shape.

As shown in Fig. 7A, flocks are filtered using the die 40 having a porous die face 41 on the side surface thereof. The flocks are laminated as a layer continuing in a surface direction of the porous die face 41. In this way, the thin piece body laminate 400S composed of the cylindrical part 400a and the truncated cylindrical part 400b is formed, whereby a desired shape can be obtained. This thin piece body laminate 400S is constituted of a first surface 400i along an outer wall of the die 40 and a second surface 400o opposing to this first surface 400i.

Then, similar to the foregoing Embodiments 1 and 2, by way of the drying step, pressurizing step, degreasing step, impregnation step and calcination step, the C/C composite material molded body 400 composed of a cylinder having a truncated conical flange part as shown in Figs. 6A and 6B can be obtained. In this C/C composite material molded body 400, the thin piece bodies are also oriented along the first and second surfaces 400i and 400o in a boundary part, namely a joint part between the flange part and the cylindrical part, and the boundaries of the thin piece bodies are dispersed, thereby forming a molded body having a continuously uniform composition. The uniform state formed when the boundaries of the thin piece bodies are dispersed means a state where there is neither a bonding layer formed by sticking nor a break for smoothly connecting surfaces to each other such that no wrinkle is formed. Similar to Embodiment 1, according to this embodiment, it is also possible to obtain a C/C composite material molded body with high strength and high density.

(Embodiment 4)

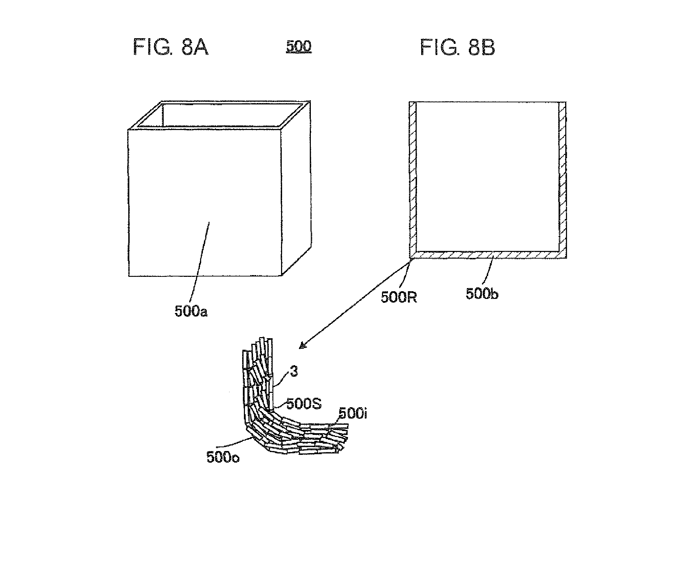

A molded body according to Embodiment 4 of the present invention is described on the basis of Fig. 8. Fig. 8A is a perspective view of a molded body of Embodiment 4, and Fig. 8B is a sectional view thereof.

A C/C composite material molded body 500 of Embodiment 4 is configured by a rectangular cylindrical part 500a having a bottom part 500b. The C/C composite material molded body 500 of this embodiment is the same as the C/C composite material molded body 100 of Embodiment 1, except for the shape of the C/C composite material molded body. In this embodiment, four planes constituting the rectangular cylindrical surface and a bottom surface are positioned vertical to each other and integrally formed in a continuous manner. Here, in a boundary region 500R between the planes orthogonal to each other, the thin piece bodies 3 are also oriented along a surface 500S, thereby constituting a uniform continuous surface, and hence, extremely high strength is revealed. Also, in this boundary region 500R, boundaries of the thin piece bodies 3 are also dispersed, thereby forming a uniform molded body. The uniform state formed when the boundaries of the thin piece bodies are dispersed means a state where there is neither a bonding layer formed by sticking nor a break for smoothly connecting surfaces to each other such that no wrinkle is formed. Similar to Embodiment I, according to this embodiment, it is also possible to obtain a C/C composite material molded body with high strength and high density.

<Example>

The C/C composite material molded body configured by a cylindrical part and a flange part continuously formed in a lower end of the cylindrical part along a peripheral surface as shown in Figs. 1A to 1E was fabricated in the following steps.

(1) Carbon fiber preparation step

PAN based carbon fibers for CFRP having an average fiber length of 150 µm and an average fiber diameter of 7 µm were prepared. Here, after a sizing agent coated on the fiber surface for the purpose of improving dispersibility into water was calcined in a reducing atmosphere at 550 °C and removed, the carbon fibers were dispersed in water and pulverized to an average fiber length of 150 µm using a mixer, followed by dehydration and drying. Then, the resulting carbon fibers were heated together with an organic material powder capable of generating a large amount of a hydrocarbon gas in a sealed vessel, and the inside of the sealed vessel was purged with a hydrocarbon gas generated from the organic material, thereby forming a reducing atmosphere.

(2) Flock forming step
(a) The carbon fibers obtained in the preceding carbon fiber preparation step were thrown into water and dispersed while stirring. Stirring was performed for about 3 minutes.
(b) Subsequently, a phenol resin ("Bell Pearl" (registered trademark) S890, manufactured by Air Water Inc.) (200 parts by mass) was added as a first binder to 100 parts by mass of the carbon fibers, and the mixture was similarly stirred for one minute.
(c) Subsequently, a latex (5 parts by mass) was added as a second binder, and the mixture was similarly stirred for one minute.
(d) Furthermore, a cationic aggregating agent ("Percol" (registered trademark) 292, manufactured by Allied Colloid Company) (0.3 parts by mass) was added as an aggregating agent, and the mixture was stirred for 20 seconds, thereby forming flocks.

(3) Flock laminate forming step (sheet-forming step)

Water having flocks formed therein was sucked from the inside of a cylindrical die provided with a wire net having an opening of 1.0 mm on an outer surface thereof to laminate the flocks on the surface of the wire net, thereby forming a cylindrical laminate. Though the wire net had an opening of 1.0 mm, the carbon fibers formed the flocks, and hence, almost all of the carbon fibers did not pass through the net. After standing for a while as it was and removing water by means of a gravitational force, the resultant was dried by a dryer at 60 °C, thereby obtaining a first molded body.

(4) Molding step (formation of laminate of thin piece body precursor (second molded body))

A wire net-free cylindrical die was inserted into the inside of the first molded body obtained in the preceding step, and the surface was further covered by a sealing film. The resultant was placed in an autoclave and pressurized while applying heat at 150 °C. A pressurizing pressure was set to 2 MPa.

(5) Curing step

Subsequent to the preceding step, the laminate was allowed to stand for 2 hours as it was under a maximum pressure in the autoclave. According to this step, the first binder (phenol resin) was cured.

(6) First degreasing step

The die of the second molded body obtained in the preceding curing step was removed, and the resultant was heated in a reducing atmosphere furnace. Heating was performed at a temperature rise rate of 70 °C/hour, and at a point of time when the temperature reached a maximum temperature of 550 °C, the resulting molded body was kept for one hour and then allowed to stand for cooling to room temperature. Incidentally, for this degreasing step, in addition to a reducing atmosphere using a hydrocarbon gas generated from an organic material, hydrogen or the like, an inert gas atmosphere using a nitrogen gas, an Ar gas or the like is also applicable.

(7) (Impregnation step)

In the case where a desired bulk density is not obtained until the first degreasing step, impregnation is further performed.

In this Example, the second molded body after degreasing was placed in an autoclave heated at 200 °C, and after drawing a vacuum, a pitch having a softening point of about 80 °C was allowed to flow in. The laminate was pressurized at 4 MPa, thereby impregnating the pitch thereinto.

(8) (Second degreasing step)

The laminate having gone through the impregnation step is again subjected to degreasing. The degreasing was performed under a condition the same as the condition in the first degreasing step of (6).

(9) Calcination step

The laminate having been subjected to the second degreasing was finally calcined. The laminate was heated at a temperature rise rate of 150 °C/hour in a reducing atmosphere, and at a point of time when the temperature reached a maximum temperature of 2,000 °C, the resulting laminate was kept for 1 seconds and then allowed to stand for cooling to room temperature. According to this calcination step, a matrix was formed from the first binder. According to the presence of the matrix, a bonding force of carbon fibers is strengthened, and strength can be revealed. In this way, there was obtained a cylindrical molded body in which a flange part was continuously formed on a cylindrical surface thereof, having an inner diameter of 1,000 mm, a height of 1,000 mm, a thickness of 25 mm, a distance of from a lower end of the cylinder to a lower part of the flange part of 30 mm, a width of the flange part of 20 mm and a height of the flange part from the cylindrical surface of 5 mm. Incidentally, this reducing atmosphere is obtained by purging with a hydrocarbon gas obtained from an organic material. Also, it is possible to use a reducing gas such as hydrogen, or to use an inert gas such as Ar and nitrogen.

<Comparative Example >

A C/C composite material molded body in which felts having the same shape as that in Example were laminated was manufactured in the following manner. First of all, PAN based carbon fibers having an average fiber length of 150 µm and an average fiber diameter of 7 µm were cut into a size of 30 mm, thereby forming a sheet-like felt. Subsequently, the felt was dipped in a methanol solution of a phenol resin, from which was then formed a carbon fiber sheet prepreg having a thickness of 3 mm by using a roll press. The thus formed carbon fiber sheet prepreg was allowed to revolve around a mandrel, thereby forming a molded body having felt-like sheets laminated thereon.

Subsequently, the resulting molded body was kept at 150 °C to cure the phenol resin, thereby fixing the shape.

Subsequently, degreasing, impregnation, degreasing and calcination were performed in the same manner as that in Example, thereby obtaining a cylindrical molded body having an inner diameter of 600 mm, a height of 600 mm and a thickness of 25 mm. A flange in a ring-like shape which was separately prepared so as to have a distance of from a lower end of the cylinder to a lower end of the flange part of 30 mm, a width of the flange part of 20 mm and a height of the flange part from the cylindrical surface of 20 mm was fitted outside the molded body, followed by bonding. A COPNA resin was used as a bonding agent, thereby forming a bonding layer between the flange and the cylindrical molded body.

<Evaluation of physical properties>

Peeling Test 1

With respect to each of the molded body obtained in Example and the molded body obtained in Comparative Example, cuts were put at intervals of a prescribed depth from an end of the C/C composite material molded body by using a knife so as to have a stratified formation, thereby comparing a peeling state.

In the molded body obtained in Example, thin piece bodies oriented in a surface direction of the molded body were formed; and when cuts were put from the end in a parallel direction to the surface of the molded body by using a knife and peeled away, the thin piece bodies were not easily separated.

In the molded body obtained in Comparative Example, cuts were put from the end in which a layer structure of annual rings was seen in a parallel direction to the surface of the molded body by using a knife and peeled away. As a result, the layer of annual rings was easily separated.

Bulk density and bending strength

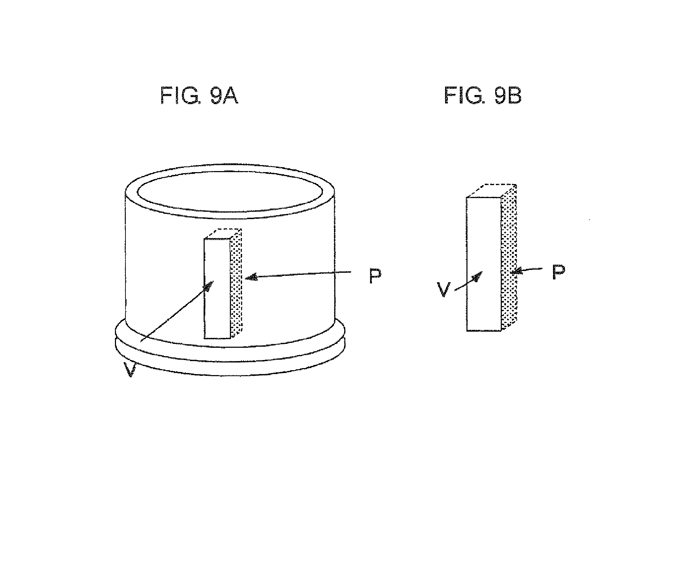

Fig. 9A is a schematic view showing a method of cutting out a sample for measuring physical properties, and Fig. 9B is a schematic view showing a test direction of a three-point bending test. As shown in Fig. 9A, two samples for measuring physical properties of a rectangular parallelepiped of 10 × 10 × 60 mm, each of which was longer in a height direction of the cylinder, were obtained from the molded body obtained in each of Example and Comparative Example. The sample for measuring physical properties was measured with respect to a bulk density and a bending strength. The bending strength was measured by performing a three-point bending test using an autograph (AG-IS Model: 0 to 5 kN), manufactured by Shimadzu Corporation while setting a span to 50 mm. With respect to the bulk density, a volume and a mass were determined, respectively. As shown in Fig. 9B, the three-point bending test was performed from two directions of a vertical direction (laminating direction of thin piece body) V and a parallel direction P relative to a surface direction of the molded body. The results of the bulk density and the bending strength are shown in Table 1.

**Table 1**

| | Bulk density (g/cm³) | Bending strength in the vertical direction ^{*1} (MPa) | Bending strength in the parallel direction ^{*2} (MPa) |
|---|---|---|---|
| Example | 1.28 | 69.0 | 75.7 |
| Comparative Example | 1.35 | 19.6 | 47.2 |

| | | | |
|---|---|---|---|
| *1: Three-point bending test from the surface direction and the vertical direction of the molded body *2: Three-point bending test from the surface direction and the parallel direction of the molded body | | | |

Peeling Test 2

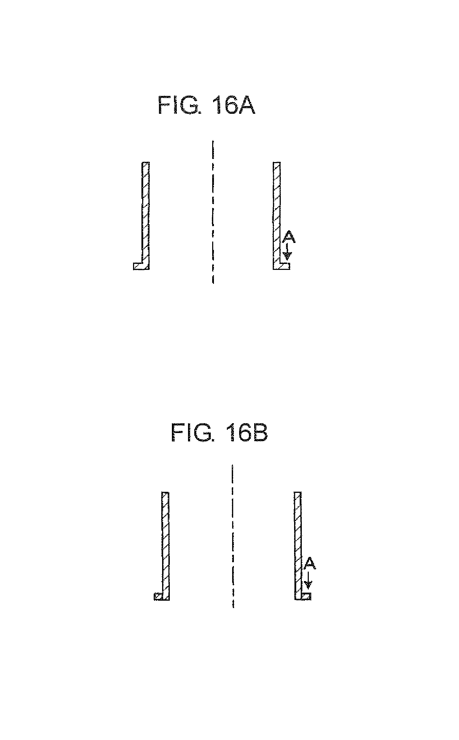

To the flange part of the molded body obtained in each of Example and Comparative Example, an impact was applied from an axial direction of the molded body by using a wooden hammer, thereby observing how the flange part was broken. Figs. 16A and 16B are views showing a method of applying an impact in Peeling Test 2, in which Fig. 16A shows Example, and Fig. 16B shows Comparative Example. In Fig. 16B, a ring-like flange is fitted in the cylindrical molded body. The symbol "A" shows a site and a direction to which the impact is applied by the wooden hammer.

As a result of performing this Peeling Test 2, in the molded body of Example, an edge part to which the impact was applied was merely crushed; whereas in the molded body of Comparative Example, a bonding part between the cylindrical molded body and the ring-like flange was peeled, and a part of the ring-like flange fell down.

Observation of surface and section

The surface and section of the molded body obtained in each of Example and Comparative Example were observed by various photographs.

Preparation method of samples for polarizing microscopic and scanning electron microscopic (SEM) photographs

A sample of a carbon fiber molded body was embedded in an epoxy resin. and a section was fabricated by means of a mechanical polishing method, followed by performing a flat milling treatment (at 45° for 3 minutes). A section having been subjected to Pt-Pd sputtering was observed by FE-SEM and a polarizing microscope. Here, the epoxy resin is one used for fixing a sample for cutting out a flat surface from a soft sample, an easily deformable sample, a fine sample or the like. For example, though an end surface of a powder, a section of a fiber or the like is in general hardly subjected to section processing, it becomes possible to achieve the observation by fixing with a fixing agent such as an epoxy resin in such a way.

(Analysis apparatus and measurement condition)
[Flat milling]
   Apparatus: Hitachi, E-3200
   Output: 5 kV, 0.5 mA
[FE-SEM]
   Apparatus: JEOL, JSM-7001F
   Accelerating voltage: 5 kV
   Observation image: Secondary electron image
[Polarizing microscope]
   Apparatus: manufactured by Nikon

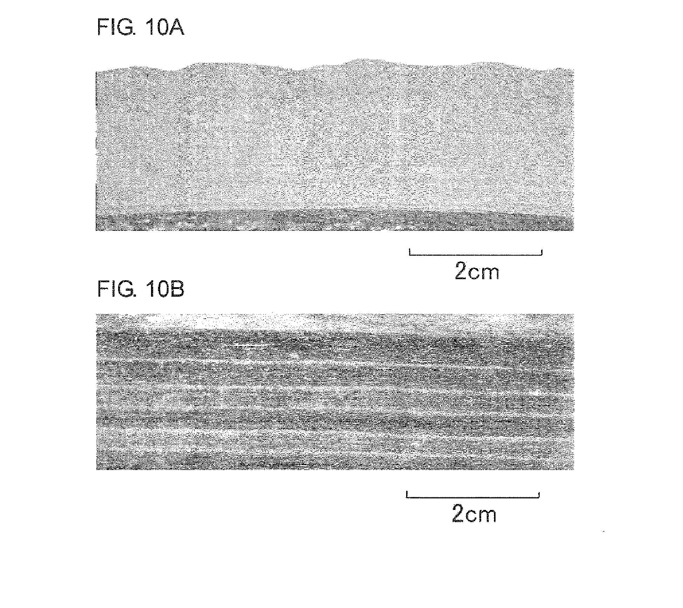

Fig. 10A is a polarizing microscopic photograph of a section of the molded body of Example, and Fig. 10B is a polarizing microscopic photograph of a section of the molded body of Comparative Example. In the molded body of Example, it is noted that a uniform molded body in which thin piece bodies oriented in a surface direction of the molded body are formed, and boundaries of the thin piece bodies are dispersed is formed. In the molded body of Comparative Example, it is noted that a layer structure of annual rings is formed.

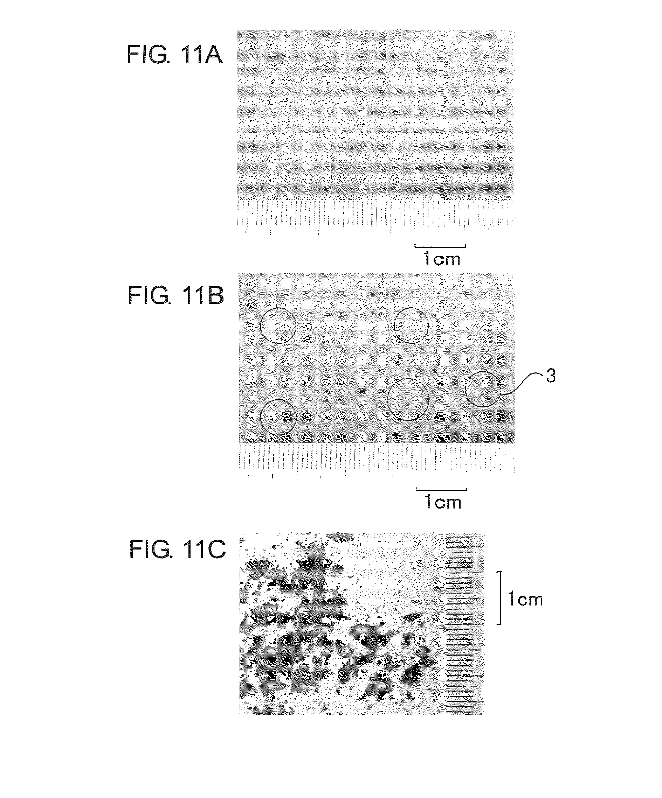

Fig. 11A is a polarizing microscopic photograph of an inner surface of the cylindrical molded body of Example. Fig. 11B shows thin piece bodies observed in the photograph of Fig. 11A. A solid line region in Fig. 11B shows each of the thin piece bodies 3. Fig. 11C shows a photograph of the thin piece bodies separated from the surface of Fig. 11A. Since the inner surface is molded by using the support material 25, a flat surface which is free from large irregularities is obtained. However, it can be confirmed that thin piece bodies oriented in parallel to the surface direction as formed from flocks are exposed on the surface. Such thin piece bodies can be gradually peeled away from a site where an end thereof is exposed because the constituting carbon fibers are oriented in parallel to the surface direction; however, the thin piece bodies are merely separated one by one, and separation reaching the whole of the carbon fiber molded body does not occur. Such separation can also be similarly confirmed on the fracture surface formed by breaking the carbon fiber molded body in a layer direction thereof.

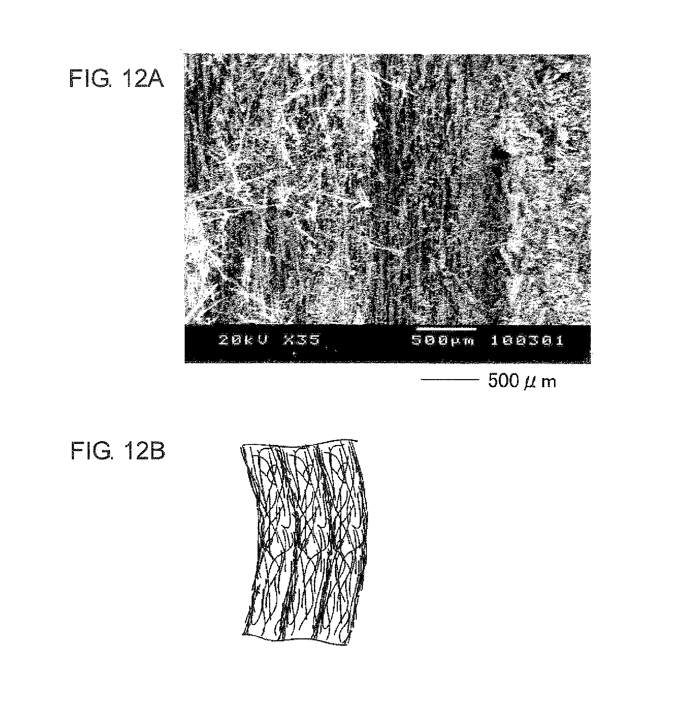

Fig. 12A shows an SEM photograph obtained by enlarging a section of the molded body of Comparative Example, and Fig. 12B shows a schematic view thereof. It can be confirmed that the fibers in a sheet interface part are strongly oriented in parallel along the boundary.

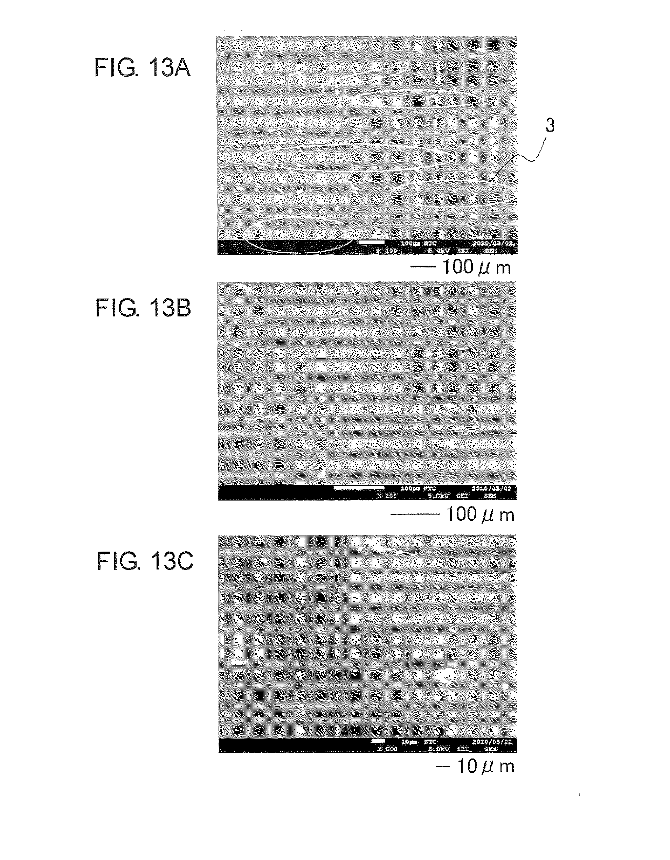

Figs. 13A to 13C are SEM photographs of a section of the molded body of Example. The vertical direction in the photograph is a thickness direction of the molded body, and the horizontal direction in the photograph is a surface direction. Fig. 13A is an SEM photograph of the molded body of Example with a magnification of 100; Fig. 13B is an SEM photograph of the molded body of Example with a magnification of 200; and Fig. 13C is an SEM photograph of the molded body of Example with a magnification of 500. Fig. 13A shows thin piece bodies observed in the SEM photograph of the section. A solid line region in Fig. 13A shows each of the thin piece bodies 3. Fig. 13B is a more enlarged SEM photograph of the thin piece body portion of Fig. 13A. Fig. 13C is a still more enlarged SEM photograph of the thin piece body portion of Fig. 13B. As shown in Fig. 13B, it can be confirmed that the thin piece bodies are laminated while being oriented in the surface direction of the carbon fiber molded body.

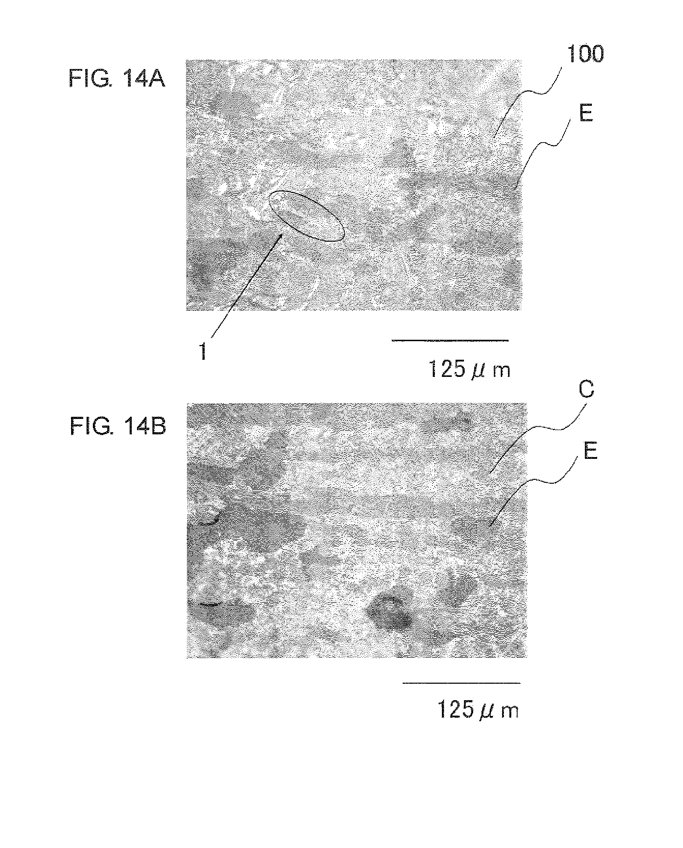

Fig. 14A is a polarizing microscopic photograph of a section of the molded body of Example. The vertical direction in the photograph is a thickness direction of the molded body (laminating direction of the thin piece body), and the horizontal direction in the photograph is a surface direction. Fig. 14A is a photograph with a magnification of 100. Fig. 14B is an SEM photograph of a section of the molded body of Comparative Example with a magnification of 200. As is confirmed by Fig. 14B, in the thin piece bodies, a region where the carbon fibers are strongly oriented in parallel in the surface direction of the carbon fiber molded body is present, and it is confirmed that in this region, connection of fibers in the thickness direction is not substantially formed. For that reason, it is noted that in Comparative Example, the region where the fibers are strongly oriented responsive to a vertical tension in the photograph of Fig. 14B becomes a defect. The vertical direction in the photograph is a thickness direction of the molded body (laminating direction of the sheet), and the horizontal direction is a surface direction. In a polarizing microscope, a different color is observed depending upon the orientation direction of a crystal, and hence, the fibers and the matrix can be easily distinguished from each other. The fibers are observed in a linear shape, an oval shape or a circular shape depending upon a relation with the observing surface. Also, a site which is deeply gray and is free light and shade in Figs 14A and 14B is an epoxy resin E used as a sealing resin, and other regions are a carbon fiber molded body (thin piece body including the matrix and the carbon fibers) in Fig. 14A and a carbon fiber molded body C in Fig. 14B, respectively.

In a region surrounded by a solid line in Fig. 14A, a carbon fiber component connecting the thin piece bodies adjoining in the vertical direction (laminating direction of the thin piece body) of the polarizing microscopic photograph to each other, could be confirmed. On the other hand, in Fig. 14B, a carbon fiber component connecting the thin piece bodies to each other could not be confirmed.

In a polarizing microscopic photograph like shown in Fig. 14A, in order that carbon fibers connecting thin piece bodies to each other may be observed, not only the carbon fibers must be present on the observing surface, but the longitudinal direction of the carbon fibers must be contained in the observed surface. In Fig. 14A, a carbon fiber component connecting the thin piece bodies adjoining in the vertical direction (laminating direction of the thin piece body) in the photograph to each other could be confirmed, and therefore, it may be said that many other carbon fiber components connecting the thin piece bodies adjoining in the vertical direction (laminating direction of the thin piece body) to each other, which cannot be observed, are also present.

As shown in the measurement results of Table 1, the three-point bending strength obtained in Example was 75.7 MPa in the vertical direction (laminating direction of the thin piece body) and 69.0 MPa in the parallel direction to the surface direction of the molded body, respectively, so that a substantially equal three-point bending strength was obtained in any of the vertical direction and the parallel direction to the surface direction of the molded body. A reason for this resides in the matter that the thin piece bodies of the molded body of Example are constituted upon being laminated, and furthermore, a homogenous molded body is obtained due to the presence of a carbon fiber component connecting the thin piece bodies adjoining in the thickness direction (laminating direction of the thin piece body) to each other.

The three-point bending strength of the molded body obtained in Comparative Example is 19.6 MPa in the vertical direction to the surface direction of the molded body, a value of which is considerably low as compared with 47.2 MPa in the parallel direction. As to a reason why in the molded body obtained in Comparative Example, the strength in the vertical direction to the surface direction of the molded body is significantly lower than that in the parallel direction, it may be considered that in the three-point bending test in the vertical direction to the surface direction of the molded body, the molded body was broken in such a manner that the laminated sheet was separated.

In the foregoing Comparative Example, the molded body is constituted through lamination of the sheets, and a carbon fiber component connecting the sheets to each other upon being oriented in the thickness direction is not present. Thus, a joining force between the sheets was weak, and in the three-point bending test in the vertical direction to the surface direction of the molded body, a remarkable lowering of the strength was found. Also, even in the three-point bending test in the parallel direction to the surface direction of the molded body, separation of the sheet was found, and only low strength was obtained as compared with that in Example.

The molded body obtained in Example is a shell-like structure configured by a continuous body having a uniform composition as a whole, and the longitudinal direction of carbon fibers is oriented along the surface. That is, it was confirmed that in the whole of the molded body including a joint part with the surface, a continuous body having a uniform composition, in which the carbon fibers are oriented along the surface, is configured. For that reason, it may be considered that a defect from the standpoint of strength is not formed in the surface-to-surface joint part or the like, and the strength in each of the vertical direction and the parallel direction to the surface direction of the molded body is increased.

Incidentally, the surface direction of the molded body as referred to herein means a principal surface constituting the molded body, and the outer surface as also referred to herein means the outer surface of the molded body but not including an edge surface. Also, a surface which after the calcination, is newly formed by means of polishing, boring or mechanical processing of the surface is not included. By taking a configuration in which the longitudinal direction of the carbon fibers is continuously oriented along the outer surface at the time of molding by the sheet-forming method, a C/C composite material molded body having extremely high mechanical strength and excellent heat resistance can be obtained.

The present invention is applicable to any shape other than the plane, such as a cylinder, a cone, a concave and a convex. In view of the fact that the present invention is useful especially for a shape requiring sticking, in the case of adopting the invention for a three-dimensional structure configured by a combination of complicated surfaces, such as a cylinder and a cone, an especially excellent effect is exhibited.

[Industrial Applicability]

Since the C/C composite material molded body according to an embodiment of the present invention is a molded body with high strength, high density and high heat resistance, it is useful for silicon single crystal pull-up apparatuses, compound semiconductor crystal pull-up apparatuses, manufacturing apparatuses of silicon for solar cell (for example, silicon thin film forming apparatuses, manufacturing apparatuses of silicon ingot, etc.), members to be used at a high temperature, such as apparatus parts in the atomic energy, nuclear fusion or metallurgy field or the like, fields required to keep high strength against a temperature change, such as space parts and aerospace parts, and so on.

## Claims

1. A C/C composite material molded body comprising:
carbon fibers; and
a carbonaceous matrix,
wherein the C/C composite material molded body has a shell-like structure, an outer surface of which is configured by a three-dimensional curved surface or a combination of a plurality of surfaces, and which is configured by a continuous structure having a uniform composition as a whole, and
wherein a longitudinal direction of the carbon fibers is oriented along the outer surface.

2. The C/C composite material molded body according to claim 1,
wherein the outer surface is any of (A) a combination of a three-dimensional curved surface and a plane or a curved surface, (B) a combination of a curved surface and a plane, (C) a combination of a curved surface and a curved surface, or (D) a combination of a plurality of planes.

3. The C/C composite material molded body according to claim 1 or 2,
wherein the carbon fibers include a linear fiber.

4. The C/C composite material molded body according to any one of claims 1 to 3,
wherein thin piece bodies in which the longitudinal direction of the carbon fibers is oriented along the outer surface of the shell-like structure are formed, and the shell-like structure is configured by a laminate of the thin piece bodies.

5. The C/C composite material molded body according to any one of claims 1 to 4, wherein the carbon fibers have an average fiber length of less than 1 mm.

6. The C/C composite material molded body according to any one of claims 1 to 5,
wherein an orienting component of the carbon fibers in a vertical direction to the outer surface of the shell-like structure is continuously present.

7. The C/C composite material molded body according to any one of claims 1 to 6,
wherein the C/C composite material molded body has a bulk density ranging from 1.2 g/cm³ to 1.8 g/cm³.

8. A method for manufacturing a C/C composite material molded body including carbon fibers and a carbonaceous matrix surrounding the carbon fibers, wherein the C/C composite material molded body has a shell-like structure, an outer surface of which is configured by a three-dimensional curved surface or a combination of a plurality of surfaces, and which is configured by a continuous structure having a uniform composition as a whole, and a longitudinal direction of the carbon fibers is oriented along the outer surface,
the method comprising:
(A) suspending the carbon fibers and a binder that is a precursor component of the carbonaceous matrix in a liquid and adding an aggregating agent to aggregate the carbon fibers and the binder, thereby forming flocks;
(B) filtering the liquid having the flocks formed therein by a die having a porous die face configured by a continuous surface of a three-dimensional curved surface or a combination of continuous plurality surfaces to laminate the flocks on a surface of the porous die face, thereby forming a laminate of flocks;
(C) pressurizing the laminate of flocks and orienting the longitudinal direction of the carbon fibers in a surface direction of the porous die face to convert the flocks into thin pieces, thereby forming a laminate of thin piece body precursor; and
(D) calcining the laminate of thin piece body precursor and carbonizing the binder to form the carbonaceous matrix, thereby forming a laminate of thin piece bodies.

9. The method according to claim 8,
wherein the filtering in the step (B) is a suction filtering.

10. The method according to claim 8 or 9,
wherein the step (A) is a step of suspending the carbon fibers including a linear fiber, a first binder that is a precursor component of the carbonaceous matrix and a second binder that is a component for coupling the carbon fibers and the first binder, in the liquid, and adding the aggregating agent to aggregate the carbon fibers, the first binder and the second binder, thereby forming the flocks.

11. The method according to any one of claims 8 to 10,
wherein the step (C) is a step of undergoing heat compression by using an autoclave in a state where the laminate of flocks is covered by a film and orienting the longitudinal direction of the carbon fibers in the surface direction of the porous die face to convert the flocks into the thin pieces, thereby forming the laminate of thin piece body precursor.
